(19) Europäisches Patentamt / European Patent Office / Office européen des brevets

(11) **EP 1 947 449 A1**

(12) **EUROPEAN PATENT APPLICATION**

(43) Date of publication:
23.07.2008 Bulletin 2008/30

(51) Int Cl.:
*G01N 24/08* (2006.01)    *G01R 33/44* (2006.01)

(21) Application number: 08000923.6

(22) Date of filing: 18.01.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(30) Priority: 22.01.2007 SI 200700014

(71) Applicant: INSTITUT JOZEF STEFAN
1000 Ljubljana (SI)

(72) Inventors:
• **Blinc, Robert, Prof. Dr.**
**1000 Ljubljana (SI)**

• **Janko, Luznik, Dr.**
**1000 Ljubljana (SI)**
• **Seliger, Janez, Prof. Dr.**
**1000 Ljubljana (SI)**
• **Trontelj, Zvonko, Prof. Dr.**
**1000 Ljubljana (SI)**
• **Tomaz, Apih, Dr.**
**1000 Ljubljana (SI)**
• **Lahajnar, Gojmir, Prof. Dr.**
**1000 Ljubljana (SI)**

(74) Representative: **Gagel, Roland**
**Patentanwalt Dr. Roland Gagel**
**Landsberger Strasse 480a**
**81241 München (DE)**

(54) **Polarization enhanced two-channel NQR/NMR detection of solid and liquid explosives using multi-pulse sequences**

(57) The objective of the present invention is the polarization enhanced two-channel NQR/NMR (PE NQR/NMR) detection of solid and liquid explosives by using the multi-pulse sequences. This is a two-channel technique of detection of solid and liquid explosives, based on the polarization enhanced nuclear quadrupole resonance (PE NQR) and proton nuclear magnetic resonance (NMR). The invention enables the detection of small amounts of solid and liquid explosives (about 100g) in burned mines or elsewhere, containing only a very small ammount of metal (arround 0.5 g in a triggering mechanism). The detection of solid and liquid explosives according to this invention is achieved by the use of a magnet for initial polarization of hydrogen nuclei in a nonzero magnetic field $B_0 \neq 0$, followed by the application of a fast NMR radio-frequency (RF) Carr-Purcell pulse sequence in the NMR channel I to see whether the proton NMR spin-spin relaxation time $T_2$ is short (microseconds) or long (milliseconds), when in the latter case it is highly probable that one deals with a liquid explosive, and with a solid explosive in the former case. The liquid explosive is further characterized in the NMR channel I, and the solid explosive in the NQR channel II. In the final step of identification of a tested explosive, the data of both channels are compared - by making use of a suitable electronic software - te with those of a data bank of all known explosives.

Fig 3a

NMR proton signal (Carr-Purcell sequence) - Channel I

NQR signal - Channel II

EP 1 947 449 A1

**Description**

**Technical field of the invention**

The present invention relates to a method of detecting $^{14}N$ and $^1H$ containing solid and liquid materials in a volume via nuclear magnetic techniques. The technical field of the present invention is the field of detection of explosives and other illicite materials.

**Background of the invention**

While we can detect metal antitank mines, burried about 10 to 15 cm below the earth surface, classically by a metal detector or perhaps by ground penetrating radar (GPR), we cannot apply successfully these methods for the detection of antipersonal mines (APM) in a plastic body containing only the minimal amount of metal (about 0.5g) in the triggering mechanism. This small amount of metal causes difficulties for the detection by the metal detector resulting in several false alarms due to small pieces of metals occasionally present in the soil. The GPR has also difficulties in detecting (and proving) small plastic APMs. Nuclear quadrupole resonance (NQR) is in such a case practically the only way to directly detect the presence of the solid explosive in a nonmetal body of a mine due to its ability to selectively detect the chemical nature of the explosive. The classical NQR offers high reliability in the detection of solid explosives, provided the detection time is long enough. In practice, however, a combination of a metal detector, the GPR and the NQR detector may be used as a solution for a faster and more reliable detection of mines containing low amounts of metal.

The classical NQR for mine detection is currently on the way to be introduced in the US Army within the following two programs:

  a) Mobile NQR detector with large coils, mounted on the vehicle and working independently or in combination with the GPR. Its duty is to reduce the false alarms. This system is used by the US Army Mine-Countermine Division for the detection and removal of mines on the streets or in mine fields.
  b) Transportable personal NQR mine detector, operating either alone or in the combination with the GPR. It is in use by the US Marine Corps for providing safe corridors across mine fields and in the buildings where mines are expected.

However, the detection of explosives via the classical NQR has the following drawbacks:

  (i) a long measuring time is necessary in the detection of some explosives with the low frequency $^{14}N$ NQR signal, like the trinitrotoluen (TNT), because a time-consuming averaging of weak NQR signals must be applied in order to get a satisfactory signal-to-noise (s/n) ratio;
  (ii) NQR is not able to detect the liquid explosives, for instance in mines PFM-1.

The first of the two mentioned drawbacks can be reduced to a large extent by a technique developed in Ljubljana at the J. Stefan institute (US) and the Institute for Mathematics, Physics and Mechanics (INIFM). It is the so called PE NQR described in the Slovene patents SI 20551, SI 20595 and 20995 and partly mentioned in the paper "Polarization enhanced "single shot" $^{14}N$ NQR detection of TNT at room temperature" by Janko Lužnik, Janez Pimat, Vojko JazbinŠek, TomaŽ Apih, Alan Gregorovič, Janez Seliger, Robert Blinc and Zvonko Trontelj (Appl. Physics Letters 89 123509 (2006).

**Summary of the invention**

It is an object of the present invention to provide a method of identifying $^{14}N$ and $^1H$ containing materials in a volume to be examined, wherein said materials may be solid and liquid materials, in particular solid and liquid explosives.
This object is achieved with the method according to claim 1. Advantageous embodiments of this method are subject of the dependent claims or are described in the subsequent portions of the description.
The above mentioned drawbacks of the prior art are eliminated by introducing an additional NMR channel which detects liquid explosives by measuring the proton NMR signal in the magnetic field used for the PE NQR.
In the proposed method, first a spin-spin relaxation time $T_2$ of protons in the volume to be examined is measured via NMR. On the basis of this measurement at least one of the following steps is performed:

  -  If the preliminary measured spin-spin relaxation time $T_2$ is longer than 1 ms, the spin-spin relaxation time $T_2$ and

the spin-lattice relaxation time $T_1$ of protons in said volume are again accurately determined via NMR. By the use of magnetic pulse gradients during NMR at least one region of higher proton density in said volume is estimated and the proton density in said at least one region is determined. Said material in said volume or region is then determined by preferably automatic comparison of the relaxation times and proton density with corresponding data of different known liquid materials in an electronic data library.

-   If the measured spin-spin relaxation time $T_2$ is shorter than 1 ms, polarization enhanced NQR is performed in said volume and said material in said volume is identified by preferably automatic comparison of the NQR frequencies. The NQR signals are measured by said polarization enhanced NQR and the corresponding NQR frequencies are compared with those known for solid materials collected in an electronic data library.

For measuring the spin-spin relaxation time $T_2$ and the spin-lattice relaxation time $T_1$ of protons in said volume via NMR a magnetic field $B_0$ is applied to said volume. The magnetic field is applied with a field strength which is sufficient to achieve an initial magnetic polarization of hydrogen nuclei in said volume. Preferably, the spin-spin relaxation time $T_2$ is first estimated in said volume by application of a NMR RF Carr-Purcell pulse sequence and, if $T_2$ is longer than 1 ms, a fast radio-frequency (RF) pulse sequence is applied to determine the spin-spin relaxation time $T_2$ and the spin-lattice relaxation time $T_1$.

For measuring signals via polarization enhanced NQR in said volume a magnetic field $B_0$ is applied to said volume. The magnetic field is applied with a field strength which is sufficient to achieve an initial magnetic polarization of hydrogen nuclei in said volume. Furthermore, a composed RF multi-pulse sequence $\alpha_0 - (\tau - \alpha_{90°} - \tau)_n$ is applied and corresponding spin echoes are detected, where n is a number of repetitions of a basic RF pulse sequence ($\tau - \alpha_{90°} - \tau$), $\alpha_{90°}$ indicates that this pulse experiences a 90° phase shift relative to the previous $\alpha_0$ pulse and $\alpha_0$ is a RF pulse width giving an optimal detected signal in a zero magnetic field $B_0 = 0$. Finally, a sequence of said spin echoes obtained is averaged. Details of such a procedure can be obtained from the documents cited in the introductory portion of this description.

The proposed method performs polarization enhanced two-channel NQR/NMR (PE NQR/NMR) detection of solid and liquid $^{14}N$ and $^1H$ containing materials, in particular explosives, by using multi-pulse sequences. This is a two-channel technique of the detection of such solid and liquid materials, based on the polarization enhanced nuclear quadrupole resonance (PE NQR) and proton nuclear magnetic resonance (NMR). The invention enables the detection of small amounts of solid and liquid explosives (around 100g) in buried mines, containing only a very small ammount of metal (about 0.5 g in a triggering mechanism) or no metal at all, as well as contraband explosive and drugs in packages and luggage.

**Description of Drawings**

This invention may be better understood and its objectives and advantages will become apparent to those skilled in the art by reference to the annexed figures. The figures show:

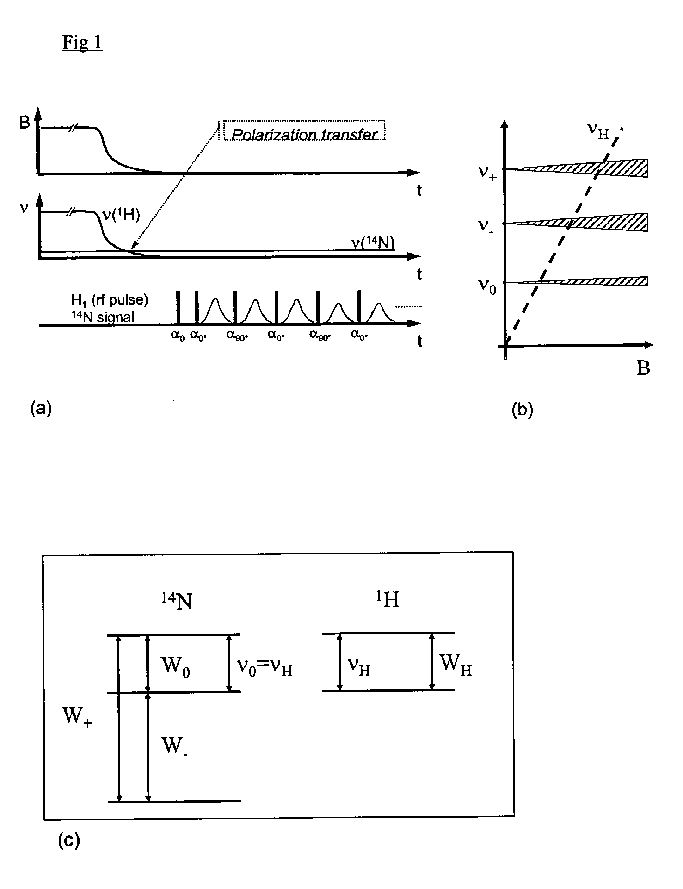

Fig. 1a    the principle of PE NQR detection of solid explosives with the transfer of polarization from the system of protons to quadrupolar nuclei in a schematic sketch; the upper line shows the time variation of the magnetic field, the second line shows the proton-nitrogen polarization transfer due to adiabatic demagnetization and proton nitrogen level crossing and the third line shows the multi-pulse RF sequence applied to the nitrogen nuclei;

Fig. 1b    proton-nitrogen level crossing in a magnetic field; the nitrogen frequencies are labeled $\nu_0$, $\nu-$, $\nu+$; the proton frequency is labeled by $\nu_H$;

Fig. 1c    the polarization transfer from the system of protons to the NQR system, consisting in our case of nitrogen nuclei, taking place in outer magnetic field when the Larmor frequency of protons equals to one of nitrogen NQR frequencies; the figure depicts energy levels of $^{14}N$ and $^1H$ at level-crossing showing the matching of the hydrogen and nitrogen transition frequencies;

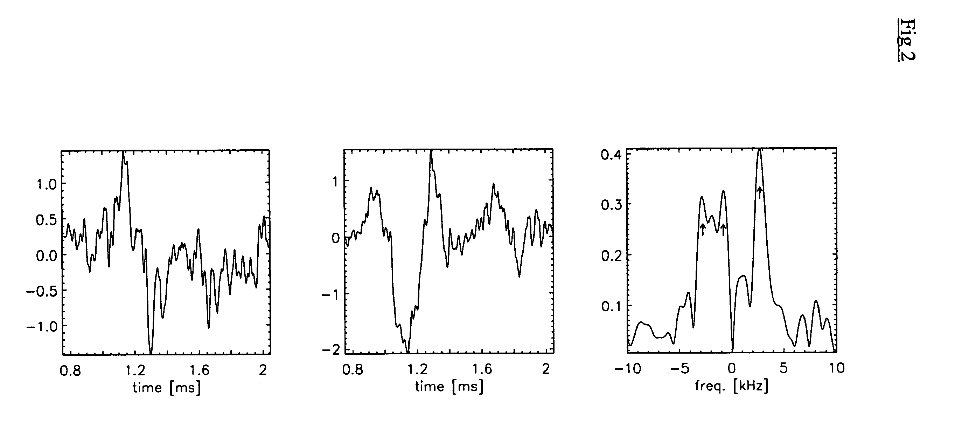

Fig 2    PE NQR "single shot" $^{14}N$ signal of monoclinic modification of TNT additionally filtered with a sharp LP filter and obtained in 20 s, wherein the absorption and dispersion signal are shown together with the frequency spectrum of 3 closely lying $^{14}N$ NQR lines (842 kHz, 844 kHz and 848 kHz); the reference frequency was chosen at 845 kHz; the three panels from left to right: absorption, dispersion, and power spectrum.; a combination of proton-nitrogen level-crossing polarization transfer and a multi-pulse spinlocking sequence $\alpha_0 - (\tau - \alpha_{90} - \tau)_n$ has been used for $^{14}N$ NQR detection;

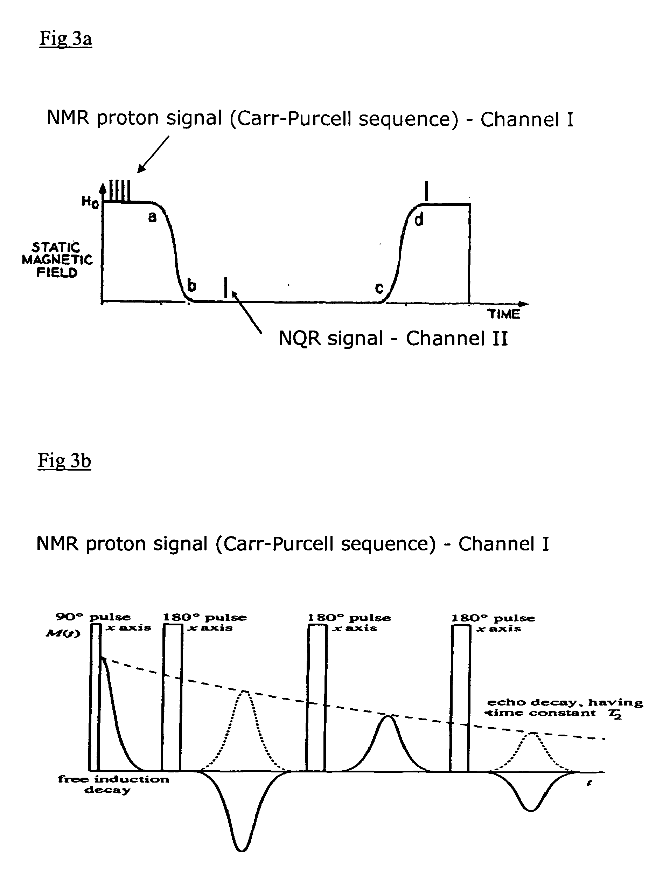

Fig 3a    Polarization enhanced two-channel NQR/NMR detection of materials; in the NMR channel I (Ch.I), that is active in the high magnetic field, we find out from the length of $T_2$ whether the detected substance is liquid or solid; the liquid explosives with long $T_2$ are detected in the Ch.I, while solid explosives with short $T_2$ in the channel II (Ch.II);

Ch. II: For solids where $T_2$ is short the system is first polarized in high magnetic field and then adiabatically demagnetized to allow for proton-nitrogen level crossing. The $^{14}$N pulsed spin locking $\alpha_0$ - ($\tau$ - $\alpha_{90}$ - $\tau$-)$_n$ sequence is then applied and the $^{14}$N NQR spin-echo signals are measured in zero magnetic field;

Ch. I: For liquids where $T_2$ is long the Carr-Purcell or related sequence is used for determination of $T_2$ when the magnetic field is still on; similarly an appropriate sequence is used to determine $T_1$ and the proton density; after a time of the order of $T_1$ the system is remagnetized and the proton signal is measured in a finite field; and

Fig. 3b    the Carr-Purcell pulse sequence for measurements of proton NMR signal in the Ch.I, i.e. in case of liquid samples.

**Detailed description of the invention**

Standard NQR detectors are successful in detecting the explosive RDX and other solid explosives, but not practical in detecting TNT because of low $^{14}$N NQR resonance frequencies of this explosive. In the latter case one has to average the measurements for a long time before one gets a reliable signal. PE NQR is here a significant improvement in comparison to classical NQR as enables one to detect in a short time also TNT. This is so because here additional polarization of the $^{14}$N quadrupole nuclei improves the s/n ratio. In doing so, the hydrogen nuclei (protons) always present in molecules of explosives, are in the first step polarized in the high magnetic field $B_0$. In the next step, during adiabatic demagnetization of a sample, the proton spin polarization established in the first step is transferred to quadrupolar nuclei ($^{14}$N) by crossing the energy levels of both nuclear species. In the third step the polarization enhanced quadrupolar signal (like in classical NQR detection) is detected when the outer magnetic field has already reached zero level. The increased s/n ratio in PE NQR is in first approximation determined by the ratio between the proton Larmor frequency ($\nu_{NMR}$) in the high polarizing magnetic field and the NQR frequency ($\nu_{NQR}$) of studied quadrupolar nuclei in the outer magnetic field (B=0). As a first approximation, the signal amplification factor is given as

$$F = \nu_{NMR}\,(^1H)/\,\nu_{NQR}(^{14}N) * \frac{N_H}{N_H + N_{^{14}N}} \;, \qquad (1)$$

where $N_H$ is the number of hydrogen nuclei and $N_{14N}$ the number of nitrogen nuclei in a molecule of the explosive. In this approximation it is supposed that dipolar coupling exists between the protons ($^1H$) and quadrupolar nuclei ($^{14}N$). The PE NQR method is schematically shown in Fig.1. Fig.1a shows the time evolution of polarizing magnetic field B, while Figs. 1b and 1c indicate the transfer of nuclear polarization from protons ($^1H$) to nitrogen nuclei ($^{14}N$) at a particular value of the magnetic field B where the NMR frequency of protons matches one of the nitrogen NQR frequencies. The detected signal is the NQR signal of $^{14}$N nuclei in zero magnetic field (B=0) (Fig.1) and is by a factor F (as given in Eq. (1)) larger than in the case of classical NQR detection. Still further increase of the s/n ratio for the $^{14}$N NQR signal is achieved by applying a suitable multi-pulse "spin-locking" sequence, in the present description and claims also referred to as the multi-pulse sequence. This is represented as:

$$\alpha_0 - (\tau - \alpha_{90°} - \tau)_n \qquad (2)$$

Here n is the number of repetitions of the basic radiofrequency (RF) pulse sequence, $\alpha_0$ is the RF pulse width giving the optimal detected signal, and $\alpha_{90°}$ indicates that this pulse experiences the 90° phase shift with respect to the previous $\alpha_0$ pulse. This modified PE NQR method is identified as the PE NQR combined with the simultaneously applied multi-pulse "spin-locking" sequence.

The advantage of the multi-pulse "spin-locking" sequence is the generation of several spin-echoes between the exciting RF pulses. After averaging them the improved s/n ratio is obtained. With the time separation $2\tau$ between RF pulses wherein spin echoes occur at $\tau$, several 10 echoes are registered in a single measurement ("single shot"). In this way the necessary detection time for a satisfactory NQR signal is essentially reduced. Using this single shot PE NQR technique in the laboratory, one can detect 15 g of the explosive TNT at room temperature in 20 s, instead in 2 hours as in case of the classical NQR technique.

It is thus obvious that the PE NQR combined with the simultaneously applied multi-pulse "spin-locking" sequence offers a possibility of fast detection of explosives, including TNT, and is suitable for military and civil applications.

This method represents also a considerable improvement in the detection of improvised explosive devices (IED) in checking passengers and baggage at airports, as it provides essential saving of time in comparison to a time-consuming classical NQR. Nevertheless, it is more expensive due to the need of a magnet and the system for cycling of the magnetic field. On the other hand, since there is no need for a high homogeneity of the magnetic field, the method is potentially applicable in practice, i.e., the improved PE NQR apparatus can be carried on the vehicles, or can be used as a portable personal PE NQR detector.

The following example describes a possible application of the improved PE NQR method. It should be emphasized, however, that this example represents only one feasible working embodiment of the invention; several modifications and variations can be made within the scope of the invention. In particular, the example refers to the use of the improved PE NQR with simultaneously applied multi-pulse "spin-locking" sequence in a laboratory detection of 15 g of the explosive TNT at room temperature with the "single shot" measurement during 20 s. The results are given in Fig.2 and demonstrate a clear and specific $^{14}$N NQR absorption and dispersion signal together with the frequency spectrum of TNT. The data show only one-half of the characteristic monoclinic modification of TNT $^{14}$N NQR spectrum, i.e., the 3 lines; the whole spectrum consists of 6 lines.

As already mentioned, all NQR techniques can detect only solid explosives. To obtain a technique able to detect also liquid explosives (like the one in mines PFM-1), the NMR channel is added to the existing PE NQR detector to obtain the resulting two-channel PE NQR/NMR detection combined with the multi-pulse "spin-locking" sequence. The existing polarization magnet of the PE NQR system is used for this additional NMR channel (Figs. 1 and 3a, b). This two-channel system can detect both the presence of liquid and solid explosives.

The measuring protocol is as follows:

1. The NMR channel (called the Channel I, or Ch. I for short) makes use of the high magnetic field $B = (0, 0, B_0)$ that polarizes the proton spins $I = 1/2$ of the explosive hydrogen nuclei. Due to Zeeman interaction the degenerate proton energy level splits into two energy levels: $E_2 = -\gamma \hbar B_0 (-1/2)$ and $E_1 = -\gamma \hbar B_0 (1/2)$. Transitions between the two Zeeman levels are induced by the applied radiofrequency (RF) pulses. A suitable RF pulse sequence is the Carr-Purcell sequence $90° - \tau - 180° - 2\tau - 180° - 2\tau - 180°$....., giving the NMR signal (spin echoes) at times $2\tau$, $4\tau$, $6\tau$, .... after the initial $90° - $ RF pulse at $t = 0$. The time decay of the resulting spin-echo train defines the value of the spin-spin relaxation time $T_2$. Based on the fact that proton $T_2$ in liquids has values of milliseconds (long $T_2$'s) and in solids of microseconds (short $T_2$'s), one can distinguish between liquid and solid explosives.

2. When the measured $T_2$ of a tested material is short, the PE NQR channel (called the Channel II, or Ch. II for short), with the zero magnetic field ($B_0 = 0$), is used for the detection of NQR signals and their frequencies, as described above.

3. When the measured $T_2$ of a tested material is long, the NMR channel, with the final value $B_0$ of the magnetic field, is chosen. The spin-spin ($T_2$) and spin-lattice ($T_1$) relaxation times are determined with a Carr-Purcell and some other suitable RF pulse sequence. Applying the magnetic field gradient pulses by means of the gradient coils (like in Magnetic Resonance Imaging for medical purposes) when the polarizing field is still on, active volume of a tested material explosive body can be determined, together with the amplitude of the proton signal that determines the proton density $\rho$ of a tested material.

4. In the final step, in case of long $T_2$, the measured $T_2$, $T_1$ and $\rho$ are compared with the information in the data bank. By applying a suitable analysis, based on the neuronal nets, the nature of a tested material can be specified. In case of short $T_2$, the measured NQR frequencies are compared with known NQR frequencies of solid materials in a data bank in order to specify the nature of the tested material.

The invention is based on the fact that liquid explosives possess characteristic values of the proton relaxation times $T_1$ and $T_2$, and density $\rho$. These values differ characteristically from corresponding values of other liquids. A single parameter can coincide with the corresponding parameter in non-explosive liquid; however, the three parameters together offer high enough reliability for liquid explosive identification and low rate of false alarms. In a very inhomogeneous tested sample the $T_2$ filter can be used to increase the reliability of measured data. The required time for a typical sample characterization is between 20 and 80 s.

An alternative possibility to successfully identify the type of a liquid explosive is to measure $^1$H or $^{13}$C chemical shifts of a tested material and thus identify the liquid explosive beyond any doubt. However, this type of NMR detection requires a very homogeneous magnetic field, i.e., an expensive magnet. Therefore, this approach cannot be considered as practical for the detection of explosives.

Summarizing the above procedure, the PE two-channel NQR/NMR detection of solid and liquid explosives using multi-pulse sequences according to the present invention is characterized by the use of a magnet for the initial magnetic polarization of hydrogen nuclei (protons) in a tested explosive in the high magnetic field $B_0$, and then by application of the fast NMR radiofrequency Carr-Purcell pulse sequence in the NMR channel I one finds out whether the proton spin-spin relaxation time $T_2$ is short ($\mu$s) or long (ms). In the case of long $T_2$ it is highly probable that one deals with a liquid explosive, while if $T_2$ is short one deals with a solid explosive. In the latter case, by means of the NQR channel II and by repeating the polarization of hydrogen nuclei in the magnetic field $B_0 \neq 0$, one subsequently applies the radiofrequency multi-pulse "spin-locking" sequence $\alpha_0 - (\tau - \alpha_{90°} - \tau)_n$. Here n is the number of repetitions of the basic radiofrequency (RF) pulse sequence, $\alpha_{90°}$ indicates that this pulse experiences the 90° phase shift with regard to the previous pulse $\alpha_0$. $\alpha_0$ is the RF pulse width required to obtain the optimal detected signal in the zero magnetic field ($B_0 = 0$). In such a case a series of spin-echoes is obtained by means of a single composite pulse sequence and, by signal averaging within such single pulse sequence, the time needed for the detection and specification also of solid explosives having NQR frequencies below 1 MHz can be made shorter by a factor of 100 or even more. When using the NMR channel I at $B_0 \neq 0$ in the case of long $T_2$, the proton spin-spin ($T_2$) and spin-lattice ($T_1$) relaxation times are determined by the fast RF pulse sequence. By applying the gradient pulses of the magnetic field, the active volume of tested explosive can be determined, and from proton signal amplitude the proton density of explosive can be also evaluated. Finally, having determined all these parameters, one can specify the tested explosive using corresponding data processing and existing library data.

However, it should be emphasized that the described example represents only one feasible working embodiment of the NQR/NMR detection of solid and liquid explosives according the invention. Various modifications and variations can be made within the scope of this invention, especially in the frame of single or combined NQR/NMR detection of explosives. For example, both channels can be also used one after another if we deal with a solid and liquid explosives in the same sample, i.e. if spin-spin relaxation times $T_2$ shorter than 1 ms as well as spin-spin relaxation times $T_2$ longer than 1 ms are measured at the same time in the sample.

## Claims

1. A method of detecting $^{14}$N and $^1$H containing solid and liquid materials, in particular solid and liquid explosives, in a volume to be examined, said method comprising at least the following steps:

   - measuring a spin-spin relaxation time $T_2$ of protons in said volume via NMR, and
   - if the measured spin-spin relaxation time $T_2$ is longer than 1 ms:

      -- determining the spin-spin relaxation time $T_2$ and a spin-lattice relaxation time $T_1$ of protons in said volume via NMR,
      -- by the use of magnetic pulse gradients estimating a region of highest proton density in said volume and determining the proton density in said region,
      -- identifying said material in said volume by comparison of the relaxation times and proton density with corresponding data of different liquid materials in an electronic data library;

   - if the measured spin-spin relaxation time $T_2$ is shorter than 1 ms:

      -- measuring NQR signals via polarization enhanced NQR in said volume, and
      -- identifying said material in said volume by comparison of the measured NQR signals with corresponding data of different solid materials in an electronic data library.

2. The method according to claim 1,
   wherein the step of measuring the spin-spin relaxation time $T_2$ of protons in said volume via NMR comprises

   - applying a magnetic field $B_0$ to said volume, said magnetic field being applied with a field strength which is sufficient to achieve an initial magnetic polarization of hydrogen nuclei in said volume, and
   - measuring the spin-spin relaxation time $T_2$ in said volume by application of a NMR RF Carr-Purcell pulse sequence.

3. The method according to claim 1 or 2,
   wherein the step of determining the spin-spin relaxation time $T_2$ and the spin-lattice relaxation time $T_1$ of protons in said volume via NMR comprises

   - applying a magnetic field $B_0$ to said volume, said magnetic field being applied with a field strength which is sufficient to achieve an initial magnetic polarization of hydrogen nuclei in said volume, and

- measuring the spin-spin relaxation time $T_2$ and the spin-lattice relaxation time $T_1$ in said volume by application of a fast RF pulse sequence.

4. The method according to one of claims 1 to 3, wherein the step of measuring signals via polarization enhanced NQR in said volume comprises

- applying a magnetic field $B_0$ to said volume, said magnetic field being applied with a field strength which is sufficient to achieve an initial magnetic polarization of hydrogen nuclei in said volume,
- applying a RF multi-pulse sequence $\alpha_0 - (\tau - \alpha_{90°} - \tau)_n$ and detecting corresponding spin echoes,

where n is a number of repetitions of a basic RF pulse sequence $(\tau - \alpha_{90°} - \tau)$, $\alpha_{90°}$ indicates that this pulse experiences a 90° phase shift relative to the previous $\alpha_0$ pulse, $\alpha_0$ is a RF pulse width giving an optimal detected signal in a zero magnetic field $B_0 = 0$,

- averaging of a series of said spin echoes obtained during application of said multi pulse sequence.

Fig 1

(a)

(b)

(c)

Fig 2

Fig 3a

NMR proton signal (Carr-Purcell sequence) - Channel I

NQR signal - Channel II

Fig 3b

NMR proton signal (Carr-Purcell sequence) - Channel I

**European Patent Office** — **EUROPEAN SEARCH REPORT**

Application Number

EP 08 00 0923

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BURNETT LOWELL J ET AL: "Signal processing considerations in NMR detection of liquid explosives" PROC SPIE INT SOC OPT ENG; PROCEEDINGS OF SPIE - THE INTERNATIONAL SOCIETY FOR OPTICAL ENGINEERING 1993 PUBL BY INT SOC FOR OPTICAL ENGINEERING, BELLINGHAM, WA, USA, vol. 1824, 16 November 1992 (1992-11-16), pages 212-222, XP002478807 * the whole document * | 1-4 | INV. G01N24/08 G01R33/44 |
| A | JP 58 208664 A (MOCHIDA PHARM CO LTD) 5 December 1983 (1983-12-05) * abstract * | 1 | |
| A | DATABASE WPI Week 200528 Thomson Scientific, London, GB; AN 2005-270793 XP002478809 -& RU 2 248 560 C2 (FEDOTOV V V) 20 March 2005 (2005-03-20) * abstract * | 1 | TECHNICAL FIELDS SEARCHED (IPC) G01R |
| A | DATABASE WPI Week 200027 Thomson Scientific, London, GB; AN 2000-315384 XP002478810 -& RU 2 128 832 C1 (UNIV KALININ) 10 April 1999 (1999-04-10) * abstract * | 1 | |

-/--

The present search report has been drawn up for all claims

| Place of search | Date of completion of the search | Examiner |
|---|---|---|
| Munich | 30 April 2008 | Skalla, Jörg |

**European Patent Office**

## EUROPEAN SEARCH REPORT

Application Number

EP 08 00 0923

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | LUZNIK JANKO ET AL: "Polarization enhanced "single shot" <14>N nuclear quadrupole resonance detection of trinitrotoluene at room temperature" APPL PHYS LETT; APPLIED PHYSICS LETTERS 2006, vol. 89, no. 12, 2006, XP002478808 * figure 1 * | 1,4 | |

-----

TECHNICAL FIELDS SEARCHED (IPC)

The present search report has been drawn up for all claims

| Place of search | Date of completion of the search | Examiner |
|---|---|---|
| Munich | 30 April 2008 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 00 0923

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2008

| Patent document cited in search report | | Publication date | Patent family member(s) | Publication date |
|---|---|---|---|---|
| JP 58208664 | A | 05-12-1983 | NONE | |
| RU 2248560 | C2 | 20-03-2005 | NONE | |
| RU 2128832 | C1 | 10-04-1999 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- SI SI20551
- SI SI20595
- SI 20995

**Non-patent literature cited in the description**

- *Appl. Physics Letters,* 2006, vol. 89, 12350